# EUROPEAN PATENT APPLICATION

(11) **EP 1 883 036 A1**
(43) Date of publication of application: **30.01.2008**
(21) Application number: 06745847.1
(22) Date of filing: 28.04.2006
(51) Int. Cl.: G06K 7/10, H01L 27/146, H01L 31/10, H04N 5/335

(54) **SOLID-STATE IMAGE PICKUP DEVICE**

(30) Priority: 28.04.2005 JP 2005132614
(71) Applicant: HAMAMATSU PHOTONICS KABUSHIKI KAISHA, Hamamatsu City Shizuoka 435-8558 (JP)
(72) Inventor: SUGIYAMA, Yukinobu, Hamamatsu Photonics K.K., Hamamatsu-shi, Shizuoka 4358558 (JP); MIZUNO, Seiichiro, Hamamatsu Photonics K.K., Hamamatsu-shi, Shizuoka 4358558 (JP)
(74) Representative: Frost, Alex John
(86) International application number: PCT/JP2006/308988
(87) International publication number: WO 2006/118250

(57) **Abstract**

There is provided a solid-state imaging device suitable for taking and analyzing binary or multilevel images including a plurality of regions that are partitioned under a certain rule. A solid-state imaging device 1 includes: (1) a photodetecting section 10 in which each pixel P_{m,n} includes photodiodes PD1_{m,n}, PD2_{m,n}, and PD3_{m,n}; (2) a first signal processor 30 for outputting a voltage value corresponding to the amount of electric charges generated in photodiodes PD1_{m,n} in selected pixels P_{m,n}; (3) a second signal processor 40 for accumulating electric charges generated in the photodiodes PD2_{m,1} to PD2_{m,N} and for outputting a voltage value corresponding to the amount of the accumulated electric charges; (4) a third signal processor 50 for accumulating electric charges generated in the photodiodes PD3_{1,n} to PD3_{M,n} and for outputting a voltage value corresponding to the amount of the accumulated electric charges; and (5) a controlling section 20 for selecting a pixel P_{m,n} for which the voltage value corresponding to the amount of electric charges generated in the photodiodes PD1_{m,n} is output from the first signal processor based on the distribution of the voltage values output from the respective second and third signal processors.

## Description

### Technical Field

The present invention relates to a solid-state imaging device capable of imaging a two-dimensional image.

### Background Art

Solid-state imaging devices for imaging a two-dimensional image are provided with a photodetecting section in which M×N pixels, each of which includes a photodiode, are two-dimensionally arranged in M rows and N columns. In each pixel of the photodetecting section, an amount of an electric charge of which corresponds to intensity of an incident light is generated in the photodiode, and accumulated therein. Data corresponding to an amount of accumulated electric charge is outputted. Subsequently, based on the data by each pixel, an image of light incident upon the photodetecting section is obtained.

Meanwhile, such solid-state imaging devices have a variety of potential applications, and application into information pickup from optical disk media based on a holographic recording and reconstruction technique has recently been considered (refer to Non-Patent Document 1). This technique is used to pick up information that is recorded on an optical disk as a hologram by applying reference light to the optical disk, utilizing a solid-state imaging device to image reconstruction light generated through the application, and analyzing an image pattern obtained through the imaging.

Solid-state imaging devices can also be used to pick up two-dimensional bar code information. In this case, information that is recorded as a two-dimensional bar code is picked up by utilizing a solid-state imaging device to image the two-dimensional bar code and analyzing an image pattern obtained through the imaging.

In the case above, images to be taken and analyzed by the solid-state imaging device are binary ones including a plurality of light and dark regions that are partitioned under a certain rule.
[Non-Patent Document 1] Hideyoshi Horimai, et al. "Holographic media near takeoff with the hope of achieving 200Gbytes during 2006," Nikkei Electronics, Jan. 17, 2005, pp.105-114

### Disclosure of the Invention

### Problems to be Solved by the Invention

However, in the case of taking and analyzing such binary or multilevel images as described above using a conventional solid-state imaging device to pick up information, it is necessary to define a plurality of regions that are partitioned under a certain rule and then to determine the brightness of each of the defined plurality of regions. That is, it is necessary to acquire data according to the amount of electric charges accumulated in every pixel included in the photodetecting section of the solid-state imaging device and then to analyze an image constituted by the data using a processor.

For this reason, it requires a long period of time to read data from the solid-state imaging device and/or to analyze images or otherwise speeding up would require a high-performance processor, and this would result in an increase in system cost. In particular, in the case of using a solid-state imaging device for information pickup from optical disk media, the speed of data readout and/or image analysis is required to be increased, but conventional solid-state imaging devices have their limits on such speedup.

The present invention has been made to solve the above-described problems, and an object thereof is to provide a solid-state imaging device suitable for taking and analyzing binary or multilevel images including a plurality of regions that are partitioned under a certain rule.

### Means for Solving the Problems

A solid-state imaging device according to the present invention includes: (1) a photodetecting section in which M×N pixels are arranged two-dimensionally in M rows and N columns, the pixel P_{m,n} in the m-th row and the n-th column including photodiodes PD1_{m,n}, PD2_{m,n}, and PD3_{m,n}, N photodiodes PD2_{m,1} to PD2_{m,N} in the m-th row being connected electrically with each other via a wiring L2ₘ, and M photodiodes PD3_{1,n} to PD3_{M,n} in the n-th column being connected electrically with each other via a wiring L3ₙ; (2) a first signal processor for outputting a voltage value corresponding to the amount of electric charges generated in photodiodes PD1_{m,n} that are included in one or more pixels P_{m,n} selected from the M×N pixels in the photodetecting section; (3) a second signal processor for receiving and accumulating electric charges generated in the N photodiodes PD2_{m,1} to PD2_{m,N} that are connected to the wiring L2ₘ and for outputting a voltage value corresponding to the amount of the accumulated electric charges; (4) a third signal processor for receiving and accumulating electric charges generated in the M photodiodes PD3_{1,n} to PD3_{M,n} that are connected to the wiring L3ₙ and for outputting a voltage value corresponding to the amount of the accumulated electric charges; and (5) a controlling section for selecting a pixel P_{m,n} for which the voltage value corresponding to the amount of electric charges generated in the photodiodes PD1_{m,n} is output from the first signal processor based on the distribution of the voltage values output from the respective second and third signal processors and for controlling the first signal processor based on the selection result. Here, M and N each represents an integer of 2 or more, "m" represents any integer equal to or greater than 1 but equal to or smaller than M, and "n" represents any integer equal to or greater than 1 but equal to or smaller than N.

In the solid-state imaging device according to the present invention, the M×N pixels included in the photodetecting section are arranged two-dimensionally in M rows and N columns, and the pixel P_{m,n} in the m-th row and the n-th column includes photodiodes PD1_{m,n}, PD2_{m,n}, and PD3_{m,n}.

The N photodiodes PD2_{m,1} to PD2_{m,N} in the m-th row of the photodetecting section are connected electrically with each other via the wiring L2ₘ. Electric charges generated in the N photodiodes PD2_{m,1} to PD2_{m,N} that are connected to the wiring L2ₘ are input and accumulated in the second signal processor, and then a voltage value corresponding to the amount of the accumulated electric charges is output from the second signal processor. The distribution of the voltage value output from the second signal processor shows the addition in the column direction of the two-dimensional intensity distribution of light incident upon the photodetecting section (i.e. one-dimensional intensity distribution in the row direction of light incident upon the photodetecting section).

The M photodiodes PD3_{1,n} to PD3_{M,n} in the n-th column of the photodetecting section are connected electrically with each other via the wiring L3ₙ. Electric charges generated in the M photodiodes PD3_{1,n} to PD3_{M,n} that are connected to the wiring L3ₙ are input and accumulated in the third signal processor, and then a voltage value corresponding to the amount of the accumulated electric charges is output from the third signal processor. The distribution of the voltage value output from the third signal processor shows the addition in the row direction of the two-dimensional intensity distribution of light incident upon the photodetecting section (i.e. one-dimensional intensity distribution in the column direction of light incident upon the photodetecting section).

The controlling section is adapted to select a pixel P_{m,n} for which the voltage value corresponding to the amount of electric charges generated in the photodiodes PD1_{m,n} is output from the first signal processor based on the distribution of the voltage values output from the respective second and third signal processors and to control the first signal processor based on the selection result. Then, the first signal processor is adapted to output a voltage value corresponding to the amount of electric charges generated in photodiodes PD1_{m,n} that are included in one or more pixels P_{m,n} selected from the M×N pixels in the photodetecting section.

Also, the first signal processor included in the solid-state imaging device according to the present invention preferably includes: (a) a row selecting section for selecting any of the M rows in the photodetecting section and for outputting a voltage value corresponding to the amount of electric charges generated in the photodiodes PD1_{m,n} that are included in the pixels P_{m,n} in the selected row to a wiring L1ₙ; and (b) a column selecting section for holding N voltage values input through each wiring L1ₙ and for selecting and outputting a voltage value corresponding to any of the N columns in the photodetecting section from the N voltage values.

In the case above, the row selecting section is adapted to select any of the M rows in the photodetecting section and to output a voltage value corresponding to the amount of electric charges generated in the photodiodes PD1_{m,n} that are included in the pixels P_{m,n} in the selected row to the wiring L1ₙ. Then, the column selecting section is adapted to hold N voltage values input through each wiring L1ₙ and to select and output a voltage value corresponding to any of the N columns in the photodetecting section from the N voltage values.

### Effect of the Invention

The solid-state imaging device according to the present invention is suitable for taking and analyzing binary or multilevel images including a plurality of regions that are partitioned under a certain rule, which allows for fast data readout.

### Brief Description of the Drawings

Fig.1 is a block diagram of a solid-state imaging device 1 according to an embodiment;
Fig.2 is a circuit diagram of each pixel P_{m,n} included in a photodetecting section 10 in the solid-state imaging device I according to the embodiment;
Fig.3 is a circuit diagram of a column selecting section 32 that is included in a first signal processor 30 in the solid-state imaging device 1 according to the embodiment;
Fig.4 is a circuit diagram of a second signal processor 40 in the solid-state imaging device 1 according to the embodiment;
Fig.5 shows a two-dimensional light intensity distribution and voltage value distributions Vv (m) and Vh (n), where Fig.5-(a) shows a two-dimensional light intensity distribution at the photodetecting section 10 in the solid-state imaging device I according to the embodiment, Fig.5-(b) shows a voltage value distribution Vv (m) output from the second signal processor 40, and Fig.5-(c) shows a voltage value distribution Vh (n) output from the third signal processor 50;
Fig.6 is a timing chart illustrating a data readout operation of the first signal processor 30 in the solid-state imaging device 1 according to the embodiment; and
Fig.7 shows a two-dimensional light intensity distribution and voltage value distributions Vv (m) and Vh (n), where Fig.7-(a) shows a two-dimensional light intensity distribution at the photodetecting section 10 in the solid-state imaging device 1 according to the embodiment, Fig.7-(b) shows a voltage value distribution Vv (m) output from the second signal processor 40, and Fig.7-(c) shows a voltage value distribution Vh (n) output from the third signal processor 50.

### Description of Symbols

- 1:: Solid-state imaging device
- 10:: Photodetecting section
- 20:: Control section
- 30:: First signal processor
- 31:: Row selecting section
- 32:: Column selecting section
- 33:: Hold circuit
- 34:: Decoder circuit
- 35:: Subtracting circuit
- 40:: Second signal processor
- 41:: D-flip-flop
- 42:: Integrating circuit
- 50:: Third signal processor

### Best Modes for Carrying Out the Invention

The best mode for carrying out the present invention will hereinafter be described in detail with reference to the accompanying drawings. It is noted that in the descriptions of the drawings, identical components are designated by the same reference numerals to omit overlapping description.

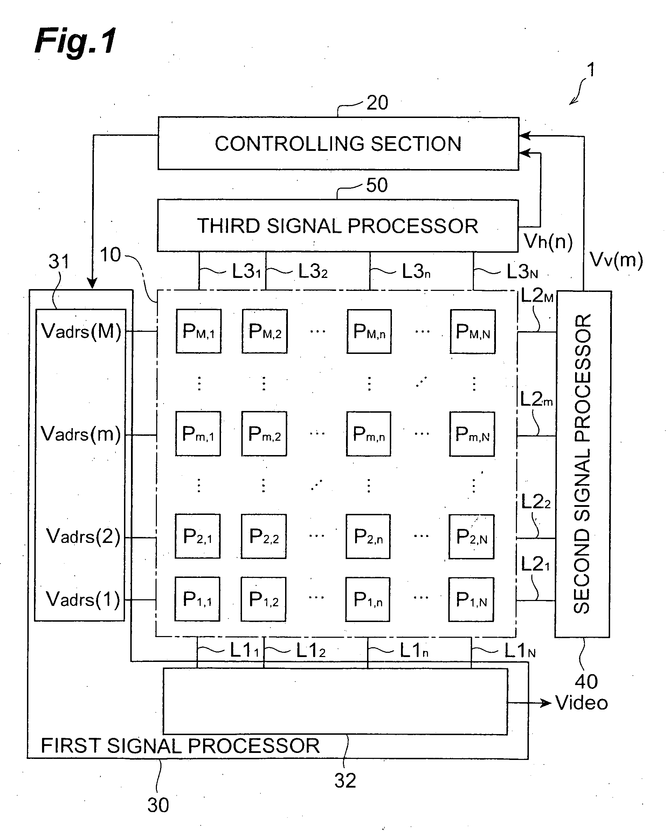

Fig.1 is a block diagram of a solid-state imaging device 1 according to an embodiment. The solid-state imaging device 1 shown in this drawing includes a photodetecting section 10, a controlling section 20, a first signal processor 30, a second signal processor 40, and a third signal processor 50.

The photodetecting section 10 includes M×N pixels P_{1,1} to P_{M,N} arranged two-dimensionally in M rows and N columns. The pixel P_{m,n} is positioned in the m-th row and the n-th column. Each pixel P_{m,n} has a common composition including photodiodes PD1_{m,n}, PD2_{m,n}, and PD3_{m,n} adapted to generate electric charges in response to incidence of light. Here, M and N each represents an integer of 2 or more, "m" represents any integer equal to or greater than 1 but equal to or smaller than M, and "n" represents any integer equal to or greater than 1 but equal to or smaller than N.

The N pixels P_{m,1} to P_{m,N} in the m-th row are given a common control signal from the first signal processor 30. The M pixels P_{1,n} to P_{M,n} in the n-th column are connected with the first signal processor 30 via a common wiring L1ₙ. Each pixel P_{m,n} is adapted to output a voltage value to the wiring L1ₙ, the voltage value corresponding to the amount of electric charges generated in the photodiode PD1_{m,n} that is included in the pixel P_{m,n}.

The first signal processor 30 is adapted to output a voltage value corresponding to the amount of electric charges generated in photodiodes PD1_{m,n} that are included in one or more pixels P_{m,n} selected from the M×N pixels in the photodetecting section 10. The first signal processor 30 includes a row selecting section 31 and a column selecting section 32.

The row selecting section 31 is adapted to select any of the M rows in the photodetecting section 10 and to output a voltage value corresponding to the amount of electric charges generated in the photodiodes PD1_{m,n} that are included in the pixels P_{m,n} in the selected row to the wiring L1ₙ. The column selecting section 32 is adapted to hold N voltage values input through each wiring L1ₙ and to select and output a voltage value corresponding to any of the N columns in the photodetecting section 10 from the N voltage values.

That is, the first signal processor 30 can output a voltage value corresponding to the amount of electric charges generated in photodiodes PD1_{m,n} that are included in one or more pixels P_{m,n} selected from the M×N pixels in the photodetecting section 10 by specifying any of the M rows in the photodetecting section 10 through the row selecting section 31 and any of the N columns in the photodetecting section 10 through the column selecting section 32.

Photodiodes PD2_{m,1} to PD2_{m,N} included in the respective N pixels P_{m,1} to P_{m,N} in the m-th row are connected electrically with each other via a common wiring L2ₘ and connected to the second signal processor 40 via the wiring L2ₘ. The second signal processor 40 is adapted to receive and accumulate electric charges generated in the N photodiodes PD2_{m,1} to PD2_{m,N} that are connected to the wiring L2ₘ and to output a voltage value corresponding to the amount of the accumulated electric charges. The distribution Vv (m) of the voltage value output from the second signal processor 40 shows the addition in the column direction of the two-dimensional intensity distribution of light incident upon the photodetecting section 10 (i.e. one-dimensional intensity distribution in the row direction of light incident upon the photodetecting section 10).

Photodiodes PD3_{1,n} to PD3_{M,n} included in the respective M pixels P_{1,n} to P_{M,n} in the n-th column are connected electrically with each other via a common wiring L3ₙ and connected to the third signal processor 50 via the wiring L3ₙ. The third signal processor 50 is adapted to receive and accumulate electric charges generated in the M photodiodes PD3_{1,n} to PD3_{M,n} that are connected to the wiring L3ₙ and to output a voltage value corresponding to the amount of the accumulated electric charges. The distribution Vh (n) of the voltage value output from the third signal processor 50 shows the addition in the row direction of the two-dimensional intensity distribution of light incident upon the photodetecting section 10 (i.e. one-dimensional intensity distribution in the column direction of light incident upon the photodetecting section 10).

The controlling section 20 is adapted to select a pixel P_{m,n} for which the voltage value corresponding to the amount of electric charges generated in the photodiodes PD1_{m,n} is output from the first signal processor 30 based on the distribution of the voltage values output from the respective second and third signal processors 40 and 50 and to control the first signal processor 30 based on the selection result.

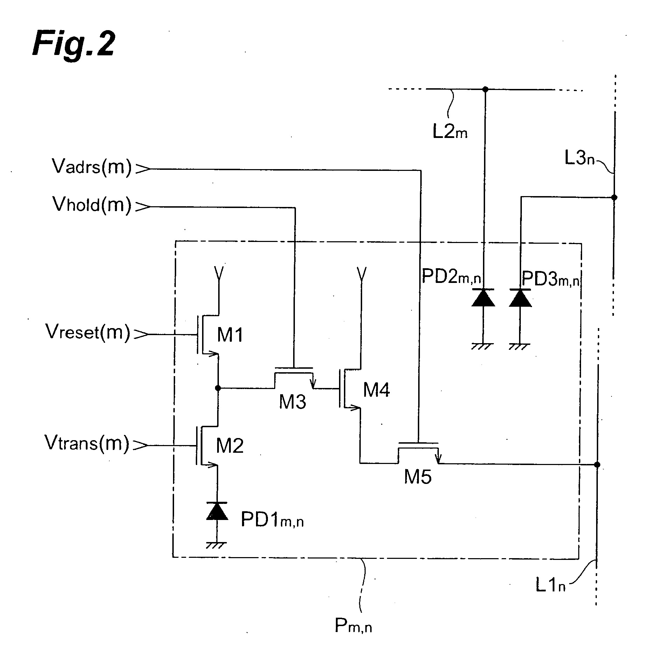

Fig.2 is a circuit diagram of each pixel P_{m,n} included in the photodetecting section 10 in the solid-state imaging device 1 according to the present embodiment. Each pixel P_{m,n} has an APS (Active Pixel Sensor) type composition including photodiodes PD1_{m,n}, PD2_{m,n}, PD3_{m,n}, and five FET transistors M1 to M5. The drain terminal of the transistor M1 is provided with a reference potential. The source terminal of the transistor M1 is connected to the drain terminal of the transistor M2. The source terminal of the transistor M2 is connected to the cathode terminal of the photodiode PD1_{m,n}. The anode terminal of the photodiode PD1_{m,n} is grounded.

The drain terminal of the transistor M3 is connected to the source terminal of the transistor M1 and the drain terminal of the transistor M2. The source terminal of the transistor M3 is connected to the gate terminal of the transistor M4. The drain terminal of the transistor M4 is provided with the reference potential. The source terminal of the transistor M4 is connected to the drain terminal of the transistor M5. The source terminal of the transistor M5 is connected to the first signal processor 30 via the wiring L1ₙ. The transistors M4 and M5 form a source follower circuit.

A signal Vreset (m) is input to the gate terminal of the transistor M1. A signal Vtrans (m) is input to the gate terminal of the transistor M2. A signal Vhold (m) is input to the gate terminal of the transistor M3. A signal Vadrs (m) is input to the gate terminal of the transistor M5. These signals Vreset (m), Vtrans (m), Vhold (m), and Vadrs (m) are output in common from the row selecting section 31 to the N pixels P_{m,1} to P_{m,N} in the m-th row of the photodetecting section 10 based on an instruction from the controlling section 20.

When the signals Vreset (m) and Vtrans (m) are at a high level, the junction capacitor of the photodiode PD1_{m,n} is discharged, and further when the signal Vhold (m) is also at a high level, the potential of the gate terminal of the transistor M4 is initialized. When the signal Vtrans (m) is at a low level, electric charges generated in the photodiode PD1_{m,n} in response to incidence of light are accumulated in the junction capacitor. When the signal Vreset (m) is at a low level and the signals Vtrans (m) and Vhold (m) are at a high level, the electric charges accumulated in the junction capacitor of the photodiode PD1_{m,n} are transferred to the gate terminal of the transistor M4, and when the signal Vadrs (m) is at a high level, a voltage value corresponding to the amount of the electric charges is output to the wiring L1ₙ.

The N photodiodes PD2_{m,1} to PD2_{m,N} in the m-th row are connected electrically with each other via the wiring L2ₘ and connected to the second signal processor 40 via the wiring L2ₘ. The second signal processor 40 accumulates electric charges input through each wiring L2ₘ and then outputs a voltage value corresponding to the amount of the accumulated electric charges. Also, the M photodiodes PD3_{1,n} to PD3_{M,n} in the n-th column are connected electrically with each other via the wiring L3ₙ and connected to the third signal processor 50 via the wiring L3ₙ. The third signal processor 50 accumulates electric charges input via each wiring L3ₙ and then outputs a voltage value corresponding to the amount of the accumulated electric charges.

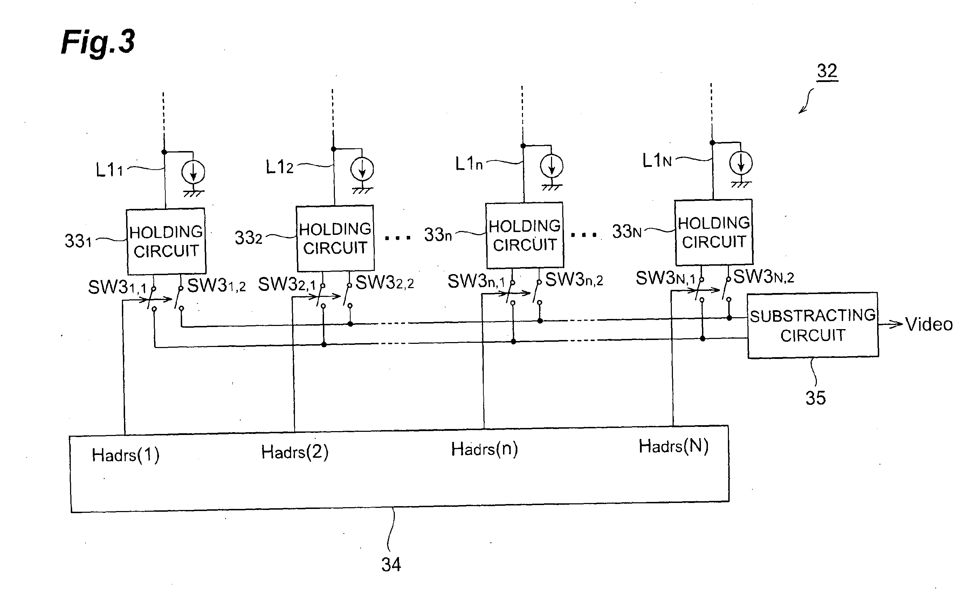

Fig.3 is a circuit diagram of the column selecting section 32 that is included in the first signal processor 30 in the solid-state imaging device 1 according to the present embodiment. The column selecting section 32 includes N holding circuits 33₁ to 33_{N}, a decoder circuit 34, a subtracting circuit 35, and 2N switches SW3_{1,1} to SW3_{N,2}.

Each holding circuit 33ₙ is adapted to receive and hold a voltage value output from a pixel P_{m,n} in any row of the photodetecting section 10 to the wiring L1ₙ and then to output the held voltage value. Each holding circuit 33ₙ can hold voltage values at two different times, and in this case, one voltage value represents a noise component, while the other voltage value represents an optical output component with a noise superimposed thereon. It is noted that each wiring L1ₙ is connected with a constant current source.

The decoder circuit 34 is adapted to output a signal Hadrs (n) for controlling the opening and closing of the switches SW3_{n,1} and SW3_{n,2} based on an instruction from the controlling section 20. Two or more of the N signals Hadrs (1) to Hadrs (N) cannot be made high simultaneously, that is, one of the N signals Hadrs (1) to Hadrs (N) is made high sequentially.

The switches SW3_{n,1} and SW3_{n,2}, which are provided on the output side of each holding circuit 33ₙ, are closed when the signal Hadrs (n) output from the decoder circuit 34 is at a high level so that two voltage values output from the holding circuit 33ₙ are input to the subtracting circuit 35. The subtracting circuit 35 is adapted to output a voltage value "Video" corresponding to the difference between the two input voltage values.

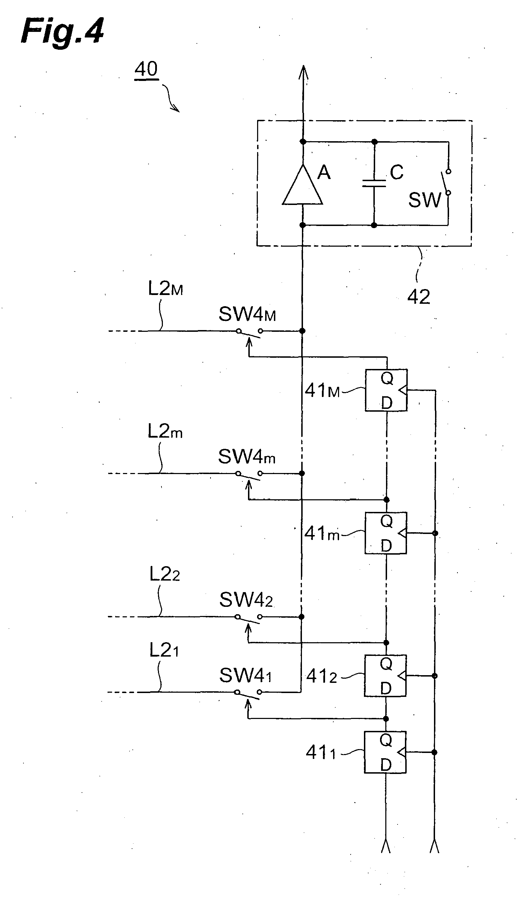

Fig.4 is a circuit diagram of the second signal processor 40 in the solid-state imaging device 1 according to the present embodiment. The second signal processor 40 includes M D-flip-flops 41₁ to 41_{M}, an integrating circuit 42, and M switches SW4₁ to SW4_{M}. The M D-flip-flops 41₁ to 41_{M} are connected in a cascade manner to form a shift register. The operation of the shift register allows logic levels output from the Q output terminals of the respective M D-flip-flops 41₁ to 41_{M} to be made high sequentially, so that the M switches SW4₁ to SW4_{M} are closed sequentially and the M wirings L2₁ to L2_{M} are connected sequentially to the integrating circuit 42. In the integrating circuit 42, a capacitive element C and a switch SW that are connected parallel with each other are provided between the input and output terminals of an amplifier A. The integrating circuit 42 can accumulate input electric charges in the capacitive element C by opening and closing the switch SW at a predetermined timing and then output a voltage value corresponding to the amount of the accumulated electric charges.

The voltage value output from the integrating circuit 42 in the second signal processor 40 corresponds to the summation of electric charges generated in the N photodiodes PD2_{m,1} to PD2_{m,N} in the m-th row that are connected to the wiring L2ₘ, and the value is to be output sequentially for each row. That is, the distribution Vv (m) of the voltage value output from the integrating circuit 42 in the second signal processor 40 shows the addition in the column direction of the two-dimensional intensity distribution of light incident upon the photodetecting section 10 (i.e. one-dimensional intensity distribution in the row direction of light incident upon the photodetecting section 10).

The configuration of the third signal processor 50 is the same as that of the second signal processor 40, where the second signal processor 40 shown in Fig.4 is replaced with third signal processor 50 and the M wirings L2₁ to L2_{M} are replaced with N wirings L3₁ to L3_{N}. That is, the voltage value output from the third signal processor 50 corresponds to the summation of electric charges generated in the M photodiodes PD3_{1,n} to PD3_{M,n} in the n-th column that are connected to the wiring L3ₙ, and the value is to be output sequentially for each column. That is, the distribution Vh (n) of the voltage value output from the third signal processor 50 shows the addition in the row direction of the two-dimensional intensity distribution of light incident upon the photodetecting section 10 (i.e. one-dimensional intensity distribution in the column direction of light incident upon the photodetecting section 10).

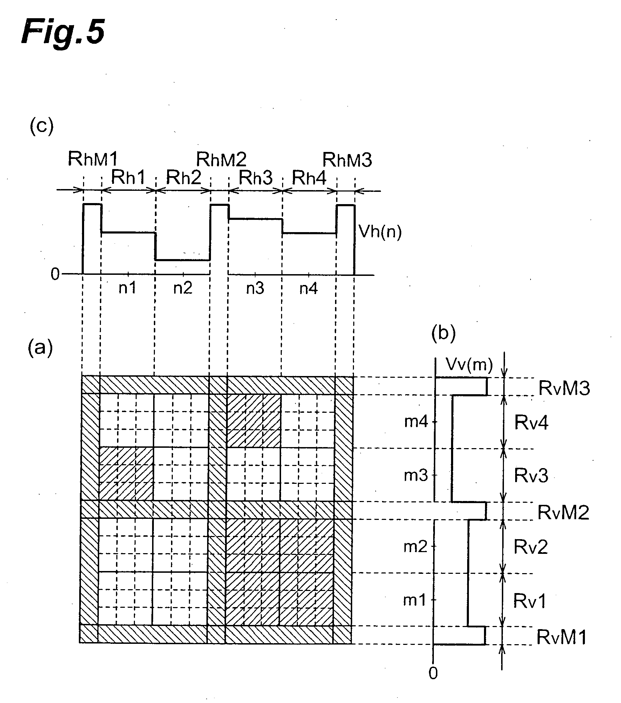

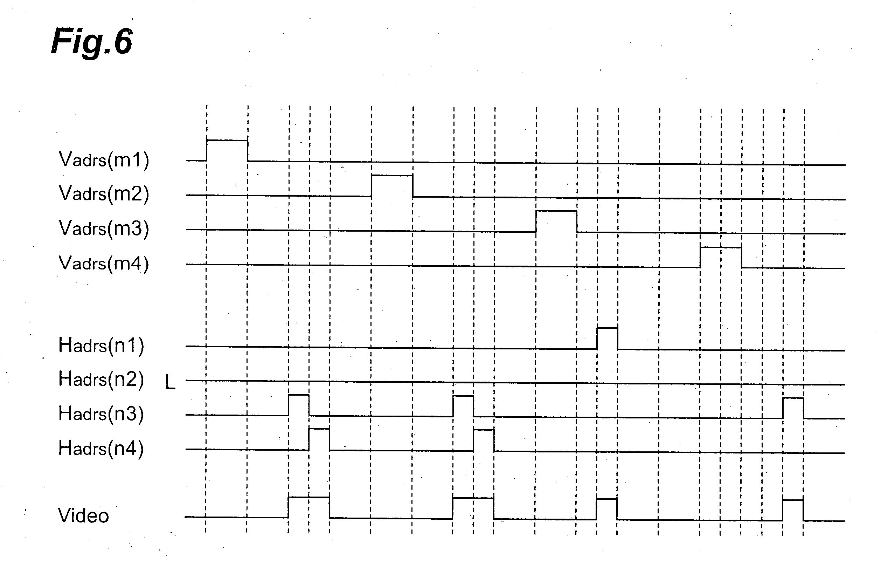

Next will be described an example of the operation of reading only desired pixels in the solid-state imaging device 1 according to the present embodiment with reference to Figs.5 and 6. The operations to be described below are under the control of the controlling section 20.

Fig.5 shows a two-dimensional light intensity distribution and voltage value distributions Vv (m) and Vh (n), where Fig.5-(a) shows a two-dimensional light intensity distribution at the photodetecting section 10 in the solid-state imaging device 1 according to the present embodiment, Fig.5-(b) shows a voltage value distribution Vv (m) output from the second signal processor 40, and Fig.5-(c) shows a voltage value distribution Vh (n) output from the third signal processor 50.

As shown in this drawing, an optical image arriving at the photodetecting section 10 is a binary one in which 16 solid square regions each having a certain area and arranged in four rows and four columns are each light or dark. Desired regions to be read out are indicated by the diagonal hatching from bottom left to top right in the drawing. Also, marker rows and columns are provided as, for example, light regions in such a manner as to surround two rows and two columns, being indicated by the diagonal hatching from top left to bottom right in the drawing. Furthermore, each rectangular region surrounded by broken lines corresponds to one pixel. Here, the positions of the desired regions to be read out with respect to the marker rows and columns are specified externally through the controlling section 20.

In the case above, in the voltage value distribution Vv (m) output from the second signal processor 40, the values in the row ranges RvM1, RvM2, and RvM3 are approximately greater than those in the other row ranges, whereby the marker rows can be identified. Also, in the voltage value distribution Vh (n) output from the third signal processor 50, the values in the column ranges RhMl, RhM2, and RhM3 are approximately greater than those in the other column ranges, whereby the marker columns can be identified. Since the marker rows and columns can be identified, square regions to be read out that are specified externally through the controlling section 20 can also be identified.

Since each square region is entirely light or dark, it is only required to obtain the intensity of light incident upon one pixel in each square region (e.g. pixel at the center of each square region). Therefore, as shown in the drawing, referring to the center rows in the respective row ranges Rv1, Rv2, Rv3, and Rv4, respectively, as m1-th, m2-th, m3-th, and m4-th rows and to the center columns in the respective column ranges Rh1, Rh2, Rh3, and Rh4, respectively, as n1-th, n2-th, n3-th, and n4-th columns, it is only required to obtain the intensity of light incident upon one pixel in each of six regions in total to be read out including two pixels P_{m1,n3} and P_{m1,n4} in the m1-th row, two pixels P_{m2,n3} and P_{m2,n4} in the m2-th row, one pixel P_{m3,n1} in the m3-th row, and one pixel P_{m4,n3} in the m4-th row.

In obtaining the intensity of light incident upon each of these six pixels, electric charges generated in photodiodes PD1_{m,n} may be accumulated simultaneously for only the pixels P_{m,n} in the m1-th, m2-th, m3-th, and m4-th rows, or electric charges generated in photodiodes PD1_{m,n} may be accumulated simultaneously for all of the M×N pixels. In the former case, signals Vreset (m), Vtrans (m), and Vhold (m) are supplied in common from the row selecting section 31 to the pixels in the m1-th, m2-th, m3-th, and m4-th rows of the photodetecting section 10, and electric charges generated in the photodiodes PD1_{m,n} in these pixels are accumulated simultaneously in the respective junction capacitors. Also, in the latter case, signals Vreset (m), Vtrans (m), and Vhold (m) are supplied in common from the row selecting section 31 to all the pixels in the photodetecting section 10, and electric charges generated in the photodiodes PD1_{m,n} in all the pixels are accumulated simultaneously in the respective junction capacitors.

After electric charges generated in the photodiode PD1_{m,n} in each pixel of the photodetecting section 10 are accumulated in each junction capacitor, data is transferred from the photodetecting section 10 to the column selecting section 32 in the first signal processor 30. This data transfer is performed only for the m1-th, m2-th, m3-th, and m4-th rows. That is, four signals Vadrs (m1), Vadrs (m2), Vadrs (m3), and Vadrs (m4) among the M signals Vadrs (m) output from the row selecting section 31 are made high sequentially, and then data output from the pixels P_{m,n} in each row is held by the holding circuit 33ₙ.

After data output from the pixels P_{m,n} in any row of the photodetecting section 10 is held by the holding circuit 33ₙ, the data is output from each holding circuit 33ₙ to the subtracting circuit 35. This data output is performed only for the n3-th and n4-th columns for the m1-th row, only for the n3-th and n4-th columns for the m2-th row, only for the n1-th column for the m3-th row, and only for the n3-th column for the m4-th row. That is, among the N signals Hadrs (n) output from the decoder circuit 34, only signals indicating desired columns to be read out among the three signals Hadrs (n1), Hadrs (n3), and Hadrs (n4) are made high sequentially when data is read out from each row, and then the data is output sequentially from the holding circuits 33ₙ₁, 33ₙ₃, and 33ₙ₄ to the subtracting circuit 35.

Fig.6 is a timing chart illustrating a data readout operation of the first signal processor 30 in the solid-state imaging device I according to the present embodiment. In this drawing, signals Vadrs (m1), Vadrs (m2), Vadrs (m3), and Vadrs (m4) output from the row selecting section 31, signals Hadrs (n1), Hadrs (n2), Hadrs (n3), and Hadrs (n4) output from the decoder circuit 34, and a voltage value "Video" output from the subtracting circuit 35 are shown.

The signal Vadrs (m1) output from the row selecting section 31 is made high during a certain period of time, and then signals indicating desired columns to be read out among the signals Hadrs (n1), Hadrs (n3), and Hadrs (n4) output from the decoder circuit 34 are made high sequentially during a certain period of time when data is read out from each row. The levels of the signals Vreset (m1) and Vhold (m1) change at predetermined timings while the signal Vadrs (m1) is at a high level, which allows a voltage value (optical output components and noise components) output from each pixel P_{m1,n} in the m1-th row to the wiring L1ₙ to be held by the holding circuit 33ₙ in the column selecting section 32.

Also, the switches SW3_{n3,1} and SW3_{n3,2} that are provided on the output side of the holding circuit 33ₙ₃ are closed while the signal Hadrs (n3) is at a high level, so that two voltage values are output from the holding circuit 33ₙ₃ to the subtracting circuit 35, which allows a voltage value (excluding noise components) "Video" corresponding to the intensity of light incident upon the pixel P_{m1,n3} to be output from the subtracting circuit 35.

Furthermore, the switches SW3_{n4,1} and SW3_{n4,2} that are provided on the output side of the holding circuit 33ₙ₄ are closed while the signal Hadrs (n4) is at a high level, so that two voltage values are output from the holding circuit 33ₙ₄ to the subtracting circuit 35, which allows a voltage value (excluding noise components) "Video" corresponding to the intensity of light incident upon the pixel P_{m1,n4} to be output from the subtracting circuit 35.

Subsequently, in the same way as described above, the signal Vadrs (m2) output from the row selecting section 31 is made high during a certain period of time, and then the signals Hadrs (n3) and Hadrs (n4) output from the decoder circuit 34 are made high sequentially during a certain period of time. This allows voltage values (excluding noise components) "Video" corresponding to the intensity of light incident upon the respective pixels P_{m2,n3} and P_{m2,n4} to be output sequentially from the subtracting circuit 35.

Also, the signal Vadrs (m3) output from the row selecting section 31 is made high during a certain period of time, and then only the signal Hadrs (n1) output from the decoder circuit 34 is made high during a certain period of time. This allows a voltage value (excluding noise components) "Video" corresponding to the intensity of light incident upon the pixel P_{m3,n1} to be output from the subtracting circuit 35.

Furthermore, the signal Vadrs (m4) output from the row selecting section 31 is made high during a certain period of time, and then only the signal Hadrs (n3) output from the decoder circuit 34 is made high during a certain period of time. This allows a voltage value (excluding noise components) "Video" corresponding to the intensity of light incident upon the pixel P_{m4,n3} to be sequentially output from the subtracting circuit 35.

As described above, the voltage values "Video" corresponding to the intensity of incident light are obtained for the six pixels in total including two pixels P_{m1,n3} and P_{m1,n4} in the m1-th row, two pixels P_{m2,n3} and P_{m2,n4} in the m2-th row, one pixel P_{m3,n1} in the m3-th row, and one pixel P_{m4,n3} in the m4-th row.

In the case of using a conventional solid-state imaging device, it is necessary to read data from all the pixels included in the photodetecting section and then to analyze all the readout data. On the other hand, in the case of using a solid-state imaging device 1 according to the present embodiment, if desired pixels to be read out are determined and six pixels from which data is to be read out are selected by the first signal processor 30, it is thereafter only required to read data from these six pixels and then to analyze the six readout data sets. Thus, using the solid-state imaging device 1 according to the present embodiment allows binary or multilevel images including a plurality of regions that are partitioned under a certain rule to be taken and analyzed in a short period of time. That is, information in desired regions to be read out that exist randomly in an image can be read out selectively only for required portions within the desired regions.

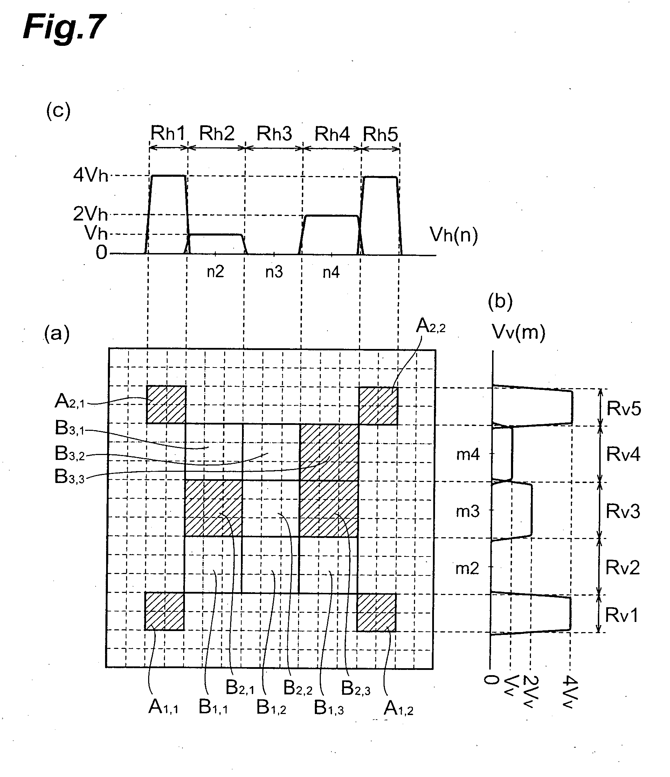

Next will be described an operation example including determining pixels to be read out in the solid-state imaging device 1 according to the present embodiment with reference to Fig.7.

The operations to be described below are also under the control of the controlling section 20, and the pixels to be read out are determined and read out based on markers included in the image to be read out.

Fig.7 shows a two-dimensional light intensity distribution and voltage value distributions Vv (m) and Vh (n), where Fig.7-(a) shows a two-dimensional light intensity distribution at the photodetecting section 10 in the solid-state imaging device 1 according to the present embodiment, Fig.7-(b) shows a voltage value distribution Vv (m) output from the second signal processor 40, and Fig.7-(c) shows a voltage value distribution Vh (n) output from the third signal processor 50.

As shown in this drawing, an optical image arriving at the photodetecting section 10 is a binary one in which 289 square unit regions (partitioned by broken lines in the drawing) each having a certain area and arranged in 17 rows and 17 columns are each light or dark. Light regions are indicated by the hatching in the drawing. This image also has reference regions A_{1,1} to A_{2,2} each including 2×2 unit regions adjacent to each other and information regions B_{1,1} to B_{3,3} each including nine unit regions. The four reference regions A_{1,1} to A_{2,2} are arranged at the four vertices of a virtual square and always form light regions. These regions serve as markers. On the other hand, the nine information regions B_{1,1} to B_{3,3} are arranged in three rows and three columns within the area surrounded by the four reference regions A_{1,1} to A_{2,2} and are each light or dark.

In the case above, in the voltage value distribution Vv (m) output from the second signal processor 40, the values in the ranges Rv1, Rv2, Rv3, Rv4, and Rv5 are approximately 4Vv, 0, 2Vv, Vv, and 4Vv respectively. Also, in the voltage value distribution Vh (n) output from the third signal processor 50, the values in the ranges Rh1, Rh2, Rh3, Rh4, and Rh5 are approximately 4Vh, Vh, 0, 2Vh, and 4Vh respectively. Here, Vv represents a value of the voltage value distribution Vv (m) in a row range corresponding to a certain unit region in case the unit region is only a light region, and Vh represents a value of the voltage value distribution Vh (n) in a column range corresponding to a certain unit region in the same case.

Then, the row ranges Rv1 and Rv5 and column ranges Rh1 and Rh5 corresponding to the reference regions A_{1,1} to A_{2,2} as well as the row ranges Rv2 to Rv4 and column ranges Rh2 to Rh4 corresponding to the information regions B_{1,1} to B_{3,3} are identified based on the voltage value distribution Vv (m) output from the second signal processor 40 and the voltage value distribution Vh (n) output from the third signal processor 50.

Since each information region is entirely light or dark, it is only required to obtain the intensity of light incident upon one pixel in each information region (e.g. pixel at the center of each information region). Therefore, as shown in the drawing, referring to the center rows in the respective row ranges Rv2, Rv3, and Rv4, respectively, as m2-th, m3-th, and m4-th rows and to the center columns in the respective column ranges Rh2, Rh3, and Rh4, respectively, as n2-th, n3-th, and n4-th columns, it is only required to obtain the intensity of light incident upon each of nine pixels in total including three pixels P_{m2,n2}, P_{m2,n3}, and P_{m2,n4} in the m2-th row, three pixels P_{m3,n2}, P_{m3,n3}, and P_{m3,n4} in the m3-th row, and three pixels P_{m4,n2}, P_{m4,n3}, and P_{m4,n4} in the m4-th row.

The operation of obtaining a voltage value corresponding to the intensity of light incident upon each of these nine pixels in the first signal processor 30 is the same as that described above. In this operation example, it is only required to determine four reference regions A_{1,1} to A_{2,2} and nine information regions B_{1,1} to B_{3,3} based on the voltage values Vv (m) and Vh (n) output from the respective second and third signal processors 40 and 50, to determine row and column ranges where the nine information regions B_{1,1} to B_{3,3} exist, to select nine pixels from which data is to be read out by the first signal processor 30, and then to read data from these nine pixels and to analyze the nine readout data sets. Thus, using the solid-state imaging device I according to the present embodiment allows binary or multilevel images including a plurality of regions that are partitioned under a certain rule to be taken and analyzed in a short period of time. That is, in this case, information in sequential information regions that exist partially in an image can be read out selectively only for required portions within the information regions.

It is noted that the present invention is not restricted to the above-described embodiment, and various modifications can be made. For example, each pixel P_{m,n} in the photodetecting section, which has an APS structure in the above-described embodiment, may have a PPS (Passive Pixel Sensor) structure.

### Industrial Applicability

The present invention is applicable to solid-state imaging devices.

## Claims

1. A solid-state imaging device comprising:
a photodetecting section in which M×N pixels are arranged two-dimensionally in M rows and N columns, the pixel P_{m,n} in the m-th row and the n-th column including photodiodes PD1_{m,n}, PD2_{m,n}, and PD3_{m,n}, N photodiodes PD2_{m,1} to PD2_{m,N} in the m-th row being connected electrically with each other via a wiring L2ₘ, and M photodiodes PD3_{1,n} to PD3_{M,n} in the n-th column being connected electrically with each other via a wiring L3ₙ;
a first signal processor for outputting a voltage value corresponding to the amount of electric charges generated in photodiodes PD1_{m,n} that are included in one or more pixels P_{m,n} selected from the M×N pixels in the photodetecting section;
a second signal processor for receiving and accumulating electric charges generated in the N photodiodes PD2_{m,1} to PD2_{m,N} that are connected to the wiring L2ₘ and for outputting a voltage value corresponding to the amount of the accumulated electric charges;
a third signal processor for receiving and accumulating electric charges generated in the M photodiodes PD3_{1,n} to PD3_{M,n} that are connected to the wiring L3ₙ and for outputting a voltage value corresponding to the amount of the accumulated electric charges; and
a controlling section for selecting a pixel P_{m,n} for which the voltage value corresponding to the amount of electric charges generated in the photodiodes PD1_{m,n} is output from the first signal processor based on the distribution of the voltage values output from the respective second and third signal processors and for controlling the first signal processor based on the selection result,
where M and N each represents an integer of 2 or more, "m" represents any integer equal to or greater than 1 but equal to or smaller than M, and "n" represents any integer equal to or greater than 1 but equal to or smaller than N.

2. The solid-state imaging device according to claim 1, wherein
the first signal processor comprises:
a row selecting section for selecting any of the M rows in the photodetecting section and for outputting a voltage value corresponding to the amount of electric charges generated in the photodiodes PD1_{m,n} that are included in the pixels P_{m,n} in the selected row to a wiring L1ₙ; and
a column selecting section for holding N voltage values input through each wiring L1ₙ and for selecting and outputting a voltage value corresponding to any of the N columns in the photodetecting section from the N voltage values.
